(19) Europäisches Patentamt / European Patent Office / Office européen des brevets

(11) **EP 2 676 151 B1**

(12) **EUROPÄISCHE PATENTSCHRIFT**

(45) Veröffentlichungstag und Bekanntmachung des Hinweises auf die Patenterteilung:
**05.04.2023   Patentblatt 2023/14**

(21) Anmeldenummer: **12704270.3**

(22) Anmeldetag: **15.02.2012**

(51) Internationale Patentklassifikation (IPC):
**G01R 33/483** (2006.01)

(52) Gemeinsame Patentklassifikation (CPC):
**G01R 33/4833**

(86) Internationale Anmeldenummer:
**PCT/EP2012/052539**

(87) Internationale Veröffentlichungsnummer:
**WO 2012/110530 (23.08.2012 Gazette 2012/34)**

(54) **ERMITTLUNG DER FORM VON RF-PULSEN FÜR DIE SELEKTIVE ANREGUNG IN DER BILDGEBENDEN MAGNETISCHEN RESONANZ**

DETERMINATION OF THE WAVEFORM OF RF-PULSES FOR SELECTIVE EXCITATION IN MRI

DÉTERMINATION DE LA FORME D'IMPULSIONS RF POUR L'EXCITATION SÉLECTIVE DANS L'IMAGERIE PAR RÉSONANCE MAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.02.2011   DE 102011004432**

(43) Veröffentlichungstag der Anmeldung:
**25.12.2013   Patentblatt 2013/52**

(73) Patentinhaber:
• **Forschungszentrum Jülich GmbH**
  **52425 Jülich (DE)**
• **Siemens Healthcare GmbH**
  **91052 Erlangen (DE)**
  Benannte Vertragsstaaten:
  **DE**

(72) Erfinder:
• **GUMBRECHT, Rene**
  **91074 Herzogenaurach (DE)**
• **VAHEDIPOUR, Kaveh**
  **50827 Köln (DE)**
• **STÖCKER, Tony**
  **40233 Düsseldorf (DE)**
• **SHAH, Nadim Joni**
  **52428 Jülich (DE)**

(74) Vertreter: **dompatent von Kreisler Selting Werner - Partnerschaft von Patent- und Rechtsanwälten mbB**
**Deichmannhaus am Dom**
**Bahnhofsvorplatz 1**
**50667 Köln (DE)**

(56) Entgegenhaltungen:
**DE-A1-102004 057 030     DE-B3-102006 058 162**

• **TONY STÖCKER ET AL: "Simulation of spin dynamics: a tool in MRI system development", JOURNAL OF PHYSICS: CONFERENCE SERIES, INSTITUTE OF PHYSICS PUBLISHING, BRISTOL, GB, Bd. 295, Nr. 1, 27. Mai 2011 (2011-05-27), Seite 12020, XP020190696, ISSN: 1742-6596, DOI: 10.1088/1742-6596/295/1/012020**
• **JELLUS V ET AL: "An NMR technique for measurement of magnetic field gradient waveforms", JOURNAL OF MAGNETIC RESONANCE, ACADEMIC PRESS, ORLANDO, FL, US, Bd. 162, Nr. 1, 1. Mai 2003 (2003-05-01), Seiten 189-197, XP004425316, ISSN: 1090-7807, DOI: 10.1016/S1090-7807(03)00084-3**

- JUSTIN. D. PEARLMAN ET AL: "Relaxivity Corrected Response Modulated Excitation (RME): A T2-Corrected Technique Achieving Specified Magnetization Patterns from an RF Pulse and a Time-Varying Magnetic Field", MAGNETIC RESONANCE IN MEDICINE, Bd. 32, 1. Januar 1994 (1994-01-01), Seiten 388-395, XP55025958,

**Beschreibung**

**Gebiet der Erfindung**

Die Erfindung betrifft ein Magnetresonanzverfahren mit einer Erzeugung von Hochfrequenzpulsen und magnetischen Gradienten ($G_x$, $G_y$, $G_z$) zur räumlich selektiven Anregung.

Es ist bekannt, dass Magnetresonanzanregungen durch Kombinationen von Hochfrequenzsignalen mit magnetischen Gradienten (insbesondere Gradientenpulsen) erzeugt werden können.

Derartige Magnetresonanzverfahren können zur Bildgebung und/oder zur Spektroskopie eingesetzt werden.

Die Erfindung betrifft ferner einen Kernspintomographen mit einem Mittel zur Erzeugung von magnetischen Gradienten, einem Mittel zur Erzeugung von Hochfrequenzpulsen, einem Mittel zur Datenakquisition und einem Mittel zur Erzeugung eines statischen Hauptmagnetfeldes.

**Stand der Technik**

Die grundlegenden Prinzipien der räumlich aufgelösten magnetischen Kernresonanz - die im Folgenden für das Verständnis der Erfindung zugrunde gelegt werden - sind beispielsweise in einer Monographie von P. Mansfield und P. G. Morris unter dem Titel "MMR Imaging in Biomedicine" (Academic Press, 1982) sowie in der Monographie von P. T. Callaghan unter dem Titel "Principles of Nuclear Magnetic Resonance Microscopy" (Clarendon Press, Oxford 1991, ISBN 0198539444) beschrieben. Ferner sind dem Lehrbuch "Magnetic Resonance Imaging" von E. Mark Haacke et al. (Wiley-Liss, 1999) detaillierte Beschreibungen zur kernmagnetischen Resonanz sowie zur kernmagnetischen Bildgebung zu entnehmen. Darüber hinaus finden sich in der vorgenannten Publikation von Haacke et al. technische und funktionelle Angaben zum Aufbau und Betrieb eines Kernspintomographen.

Pauly et al. A k-Space Analysis of Small-Tip-Angle Excitation. J Magn Reson (1998) vol. 81 (1) pp. 43-56 und Pauly et al. A Linear Class of Large-Tip-Angle Selective Excitation Pulses. J Magn Reson (1989) vol. 82 (3) pp. 571-587 beschreiben die K-Raum-Analyse und den Designansatz räumlich selektiver Magnetresonanzanregungen mit Hochfrequenzpulsen und Gradientenpulsen.

Katscher et al. Theoretiocal and nummerical aspects of transmit SENSE. IEEE T Med Img (2004) und Zhu. Parallel excitation with an array of transmit coils. Magn Reson Med (2004) vol. 51 (4) pp. 775-84 beschreiben einen Einsatz von Mehrkanalverfahren in der Magnetresonanz.

Ferner sind verschiedene Verfahren zur Berechnung der Hochfrequenzpulse bekannt (Ullmann et al. 2005, Grissom et al. 2006, Zelinski et al. 2007, Yip et al. 2007, Grissom et al. 2008, Xu et al. 2008).

Darüber hinaus werden grundlegende Methoden in Hoge et al, Density Compensation Functions for Spiral MRI. Magn Reson Med (1997) vol. 38 (1) pp. 117-128 dargestellt.

Die DE 10 2004 057 030 A1 offenbart ein System, das mehrere Sendespulen mit entsprechenden HF-Impulssynthesizern und -Verstärkern aufweist. Außerdem ist ein Verfahren zur Gestaltung von HF-Impulsen beschrieben, die für jede Sendespule spezifisch oder individuell sind, um räumlich, zeitliche Variationen in einem zusammengesetzten Magnetfeld zu erzeugen.

Die DE 10 2006 0581 62 B3 beschreibt ein Verfahren zur Gewinnung der Amplituden- und Phasenverläufe von HF-Pulsen, welche während des Durchlaufens einer vorgegebenen k-Raum-Trajektorie zur Erzeugung eines n-dimensionalen räumlichen Musters (n>=1) der transversalen Magnetisierung in einem Objekt im Rahmen eines Experiments der ortsaufgelösten magnetischen Resonanz mittels mindestens einer HF-Sendeantenne eines Magnetresonanzmesssystems (MR-Messsystems) eingestrahlt werden.

In Justin D. Pearlman et al: "Relaxivity corrected response modulated excitation (RME): A T2-corrected technique achieving specified magnetization patterns from an RF pulse and a time-varying magnetic field", Magnetic Resonance in Medicine, Bd. 32, 1. Januar 1994, Seiten 388-395, XP055025958 wurde Theorie der HF-Anregung überarbeitet, um eine Korrektur der Relaxivität zu ermöglichen und gleichzeitig eine reaktionsmodulierte Anregung (RME) zu entwickeln, um bestimmte Magnetisierungsziele zu erreichen.

Aus Jellus V et al: " An NMR technique for measurement of magnetic field gradient waveforms", Journal of Magnetic Resonance, Academic Press, Orlando, FL, US, Bd. 162, Nr. 1, 1. Mai 2003, Seiten 189-197, XP004425316 ist eine Methode zur Messung der zeitlichen Entwicklung eines Magnetfeldgradienten bekannt. Die Methode basiert auf der Analyse des NMR-Signals im Zeitbereich. Die Technik macht sich das Prinzip zunutze, dass das Erregungsprofil bei kleinen Flipwinkeln eine gute Annäherung an die Fourier-Transformierte der Hochfrequenzimpulsform ist. Die Erzeugung des NMR-Signals kann als inverse Fourier-Transformation betrachtet werden, so dass die Variation der Gradientenstärke während des Anregungspulses die Form des NMR-Signals beeinflusst. Die Magnetresonanzverfahren nach dem Stand der Technik erfordern einen hohen Zeit- und Rechenaufwand. Ein weiterer Nachteil des Standes der Technik ist, dass Störeffekte, beispielsweise Feldinhomogenität, einen großen Einfluss auf die selektive Anregung haben und dazu führen können, dass anstelle der gewünschten Selektion eine andere Selektion erfolgt.

**Aufgabe der Erfindung**

Der vorliegenden Erfindung liegt die Aufgabe zugrunde, die genannten Nachteile zu vermeiden. Insbesondere soll ein Magnetresonanzverfahren bereitgestellt werden, das es ermöglicht, mit möglichst geringem Zeit- und Rechenaufwand selektive Anregungen zu erzeugen, die unempfindlich gegenüber äußeren Störeinflüssen sind.

**Kurze Beschreibung der Erfindung**

Erfindungsgemäß wird diese Aufgabe gelöst durch ein Verfahren mit den Merkmalen des unabhängigen Anspruchs 1. Vorteilhafte Weiterbildungen des Verfahrens ergeben sich aus den Unteransprüchen 2 und 3.
Die Aufgabe wird ferner durch eine Vorrichtung nach Anspruch 4 gelöst.
Ein Beispiel, das nicht in den durch die Ansprüche definierten Schutzumfang der Erfindung fällt, sieht vor, ein Magnetresonanzverfahren mit einer Erzeugung von
Hochfrequenzpulsen und magnetischen Gradienten ($G_x$, $G_y$, $G_z$) zur selektiven Anregung eines zu untersuchenden Objektes so durchzuführen, dass ein Magnetresonanzsignal s(t) gemäß folgender Signalgleichung erzeugt wird:

$$s(t) \quad = \quad \int_V m(\vec{r}, T) \exp[t / T_2] \exp[it\omega_s] \exp[-i\vec{k}(T-t)\cdot\vec{r}] \, d^3r \quad ,$$

wobei $M(\vec{r}, T)$ eine gewünschte transversale Magnetisierung nach der selektiven Anregung, $t$ eine Zeit, $\vec{r}$ einen Ortsvektor und $T$ eine Dauer eines Pulses bezeichnen, und wobei s(t) ein Magnetresonanzsignal, $V$ ein Untersuchungsvolumen, $T_2$ eine transversale Relaxationszeit und $\omega_s$ eine Verschiebung der Resonanzfrequenz bezeichnen.

Mit der vorgestellten neuen Methode werden selektive Hochfrequenzpulse für Anwendungen in der Magnetresonanztomographie bestimmt. Das Verfahren nutzt dabei grundsätzliche physikalische und mathematische Prinzipien aus, speziell das Reziprozitätsprinzip sowie die Zeitinvarianz, um damit ein Inversionsproblem in eine äquivalente, aber wesentlich einfachere, Beschreibung zu überführen, welche auf der Akquisition eines hypothetischen Magnetresonanzsignals beruht. Dieses Signal ist bis auf Normierungsfaktoren gleich dem gesuchten Hochfrequenzpuls. Folgende Vorteile ergeben dadurch sich gegenüber den bisher bekannten Verfahren:

• Direktes (nicht-iteratives) Auffinden einer eindeutigen Lösung.
• Die Lösung ergibt sich durch Superposition analytischer Lösungen und ist somit inhärent parallelisierbar und deshalb sehr schnell verfügbar.
• Der Vorgang berücksichtigt unmittelbar Störeinflüsse wie Feldinhomogenitäten und Relaxation, so dass sich die Lösungen robust gegen diese verhalten.
• Die Methode ist ohne erhöhten nummerischen Aufwand direkt anwendbar für den Fall multipler Anregungskanäle, d.h. die selektive Anregung mit Hilfe der räumlichen Sensitivitäten mehrerer Hochfrequenz-Anregungsspulen, die nachfolgend zur Vereinfachung als Spulen bezeichnet werden.

Ein Beispiel, das nicht in den durch die Ansprüche definierten Schutzumfang der Erfindung fällt, zeichnet sich dadurch aus, dass der Hochfrequenzpuls $b_1$ (t) unter
Berücksichtigung folgender Formel erzeugt wird:

$$b_1(t) \quad = \quad \frac{J(t)}{i\gamma m_0} s(T - t) \quad ,$$

Das heißt, der Hochfrequenzpuls entspricht bis auf Faktoren dem zeit-invertierten Magnetresonanzsignal. Hierbei ist $J(t)$ die Jacobi-Determinante zur Beschreibung des k-Raum-Volumenelements entlang einer Trajektorie. Die Jacobi-Determinante J (t) leistet unter einer Prämisse der Bijektivität von k(t) auf einen Wertebereich von t eine Abhängigkeit der Koordinatentransformation zwischen der Zeit- und der K-Raum-Parametrisierung. Bei einer analytisch gegebenen k-Raum-Trajektorie lässt sich $J(t)$ explizit berechnen. So gilt z.B. bei einer archimedischen Spirale

$$J(t) = \frac{\gamma}{2\pi} |\vec{k}(t) \cdot \vec{g}(t)| \qquad \vec{g}(t) = \frac{2\pi}{\gamma} \frac{\partial \vec{k}(t)}{\partial t}$$

, wobei eine Pulsform der Gradienten beschreibt.
Die Weiterbildung des Verfahrens beruht auf der Annäherung für kleine Anregungswinkel (Small-Tip-Angle Approximation, STA) nach Pauly (1988, 1989). Demnach wird die selektiv angeregte Magnetisierung beschrieben durch:

$$m(\vec{r}, T) \;=\; i\gamma\, m_0 \exp[-T/T_2]\exp[-iT\omega_s]\int_0^T \exp[t/T_2]\exp[it\omega_s]b_1(t)\exp[i\vec{k}(t)\cdot\vec{r}]\,dt \;.$$

$$(1)$$

Dabei sind

$m(\vec{r}, T)$: gewünschte transversale Magnetisierung nach der selektiven Anregung,
$t, \vec{r}, T$ : Zeit, Ortsvektor, Dauer des Pulses,
$i, \gamma, m_0$: imaginäre Einheit, gyromagnetisches Verhältnis, Gleichgewichtsmagnetisierung,
$T_2, \omega_s$: Transversale Relaxationszeit, Verschiebung der Resonanzfrequenz ,
$b_1(t), \vec{k}(t)$ : Hochfrequenzpuls, Vektor der k-Raum Trajektorie (gegeben durch Gradienten).

Gleichung (1) formuliert ein inverses Problem, da sie aufgelöst werden muss nach dem gesuchten Hochfrequenzpuls, $b_1(t)$ , bei vorgegebener k-Raum Trajektorie der Gradienten, $k(t)$, sowie dem vorgegebenen Muster zur Anregung, $M(r, T)$, welches die Zielregion beschreibt.

Im Unterschied zur originalen Darstellung von Pauly (1988) unterscheidet sich Gleichung (1) um die zusätzliche Berücksichtigung von Störeinflüssen während des Pulses, d. h. durch die Berücksichtigung von transversaler Relaxation $T_2$ und Verschiebung der Larmorfrequenz $(\omega_s)$. Letztere kann zum Beispiel durch auftretende Inhomogenitäten des Hauptfeldes auftreten. Im Unterschied zur originalen Darstellung von Pauly (1988) unterscheidet sich Gleichung (1) um die zusätzliche Berücksichtigung von Störeinflüssen während des Pulses, d.h. durch die Berücksichtigung von transversaler Relaxation ($T_2$) und Verschiebung der Larmorfrequenz ($\omega$s). Die Verschiebung der Larmorfrequenz $(\omega_s$ ) kann zum Beispiel durch auftretende Inhomogenitäten des Hauptfeldes auftreten.

Ein Beispiel, das nicht in den durch die Ansprüche definierten Schutzumfang der Erfindung fällt, nutzt die Reziprozität zur Signalgleichung der Magnetresonanz-Bildgebung aus

$$s(t) \;=\; \int_V M(\vec{r}, T)\exp[t/T_2]\exp[it\omega_s]\exp[-i\vec{k}(T-t)\cdot\vec{r}]\,d^3r \quad , \qquad (2)$$

die in der hier vorliegenden Form allerdings eine Zeitumkehr $t : T\to 0$ beschreibt, d.h. es wird ein hypothetisches Magnetresonanzsignal s(t), resultierend aus einem Untersuchungsvolumen V, rückwärts in der Zeit berechnet entlang der rückwärts durchlaufenen k-Raum Trajektorie $k(T-t)$. Dabei ist die Ausgangsmagnetisierung durch Gleichung (1) und somit durch die Zielregion der selektiven Anregung bestimmt. Die Bestimmung des Magnetresonanzsignals kann entweder durch eine nummerische Simulation von Gleichung (2) oder in bestimmten Fällen auch direkt durch eine Messung erfolgen. Der gesuchte Hochfrequenzpuls ergibt sich dann zu

$$b_1(t) \;=\; \frac{J(t)}{i\gamma\, m_0}\, s(T-t) \qquad (3)$$

d.h. der Hochfrequenzpuls entspricht bis auf Faktoren dem zeit-invertierten Magnetresonanzsignal. Hierbei ist $J(t)$ die Jacobi-Determinante des k-Raum Volumenelements entlang der Trajektorie (Hoge et al, 1997).

Die Erfindung zeichnet sich weiterhin dadurch aus, dass zur Anregung N Spulen mit unterschiedlicher räumlicher Sendecharakteristik verwendet werden.

Denn nutzt man zur Anregung N Spulen mit unterschiedlicher räumlicher Sendecharakteristik, das heißt, man verwendet multiple Anregungskanäle (Katscher et al 2003; Zhu, 2004), dann ergibt sich der gesamte Hochfrequenzpuls als räumlich verschiedene, gewichtete Überlagerung der Pulse der einzelnen Kanäle

$$b_1(t, \vec{r}) \;=\; \sum_{n=1} \sigma_n(\vec{r})\, b_n(t) \;. \qquad (4)$$

Hierbei sind

$\sigma_n(r)$: eine bekannte ortsabhängige Sensitivität des n-ten Kanals und

$b_n(t)$: ein gesuchter Hochfrequenzpuls des n-ten Kanals.

Gleichung (4) in Gleichung (1) eingesetzt liefert die Problemstellung für die selektive Anregung im Mehrkanalfall. Entsprechend zu den Gleichungen (2) und (3) kann auch hier eine Lösung des Problems über ein hypothetisches Magnetresonanzsignal erfolgen, wobei nun n Signale mit entsprechenden Empfangssensitivitäten, $\sigma_n^*(r)$, bestimmt werden müssen('*' bezeichnet die komplexe Konjugation):

$$s_n(t) \;=\; \int_V \sigma_n^*(\vec{r})\, m(\vec{r})\, \exp[-t/T_2]\, \exp[-it\omega_s]\, \exp[-i\vec{k}(T-t)\cdot\vec{r}]\, d^3r \qquad (5)$$

Erfindungsgemäß werden nun äquivalent zum Einkanalfall diese N Signale für die oben beschriebene Magnetisierung entlang der zeit-invertierten Trajektorie, $k(T-t)$, bestimmt - durch eine nummerische Simulation von Gleichung (5) oder durch eine Messung - dann ergeben sich die gesuchten Hochfrequenzpulse analog zu Gleichung (3) zu

$$b_n(t) \;=\; \frac{J(t)}{i\gamma\, m_0}\, s_n(T-t) \qquad (6)$$

Insgesamt ist damit die Bestimmung der Hochfrequenzpulse, d.h. die Lösung von Gleichung

(1) im Einkanal- oder Mehrkanalfall, wobei nur der Mehrkanalfall in den Schutzumfang der durch die Ansprüche definierten Erfindung fällt, auf die Bestimmung von Magnetresonanzsignalen reduziert, die im Allgemeinen durch nummerisch effiziente Simulationen erfolgen kann, oder in bestimmten Anwendungen auch durch eine vorausgehende Messung erfolgen kann.

Ein weiteres Beispiel außerhalb des Schutzumfangs der Erfindung sieht einen Einsatz von Hochfrequenzpulsen zur selektiven Anregung vor, die nach Gleichungen (2) und (3) durch eine nummerische Simulation eines entsprechenden Magnetresonanzsignals erfolgt sind.

Eine Weiterentwicklung der Erfindung beinhaltet einen Einsatz von Hochfrequenzpulsen zur selektiven Anregung mit einem Mehrkanalsystem, die nach Gleichungen (5) und (6) durch eine nummerische Simulation der entsprechenden Magnetresonanzsignale erfolgt sind.

Ein weiteres Beispiel außerhalb des Schutzumfangs der Erfindung sieht einen Einsatz von Hochfrequenzpulsen zur selektiven Anregung vor, die nach Gleichungen (2) und (3) durch eine erste Messung eines entsprechenden Magnetresonanzsignals erfolgt sind, welches dann als Hochfrequenzpuls in einer zweiten Messung angewendet wird.

Eine weitere Ausgestaltung der Erfindung beinhaltet einen Einsatz von Hochfrequenzpulsen zur selektiven Anregung mit einem Mehrkanalsystem zur Anregung, die nach Gleichungen (5) und (6) durch eine erste Messung entsprechender Magnetresonanzsignale mit einem Mehrkanalsystem zum Empfang erfolgt sind, welche dann als Hochfrequenzpulse in einer zweiten Messung angewendet werden.

Eine Weiterbildung der Erfindung sieht vor, dass die magnetischen Gradienten $G_x$ und $g_y$ zur k-Raum-Codierung gleichzeitig geschaltet werden, wobei ein zeitlicher Verlauf der magnetischen Gradienten $g_x$ und $g_y$ sinus- beziehungsweise cosinus-förmig erfolgt, so dass eine spiralförmige Bedeckung des k-Raumes resultiert.

Die magnetischen Gradienten $(g_x, g_y, g_z)$ verlaufen zweckmäßigerweise orthogonal zueinander im Raum, so

$$\vec{k} = -\gamma \int \vec{g}(t)\, dt$$

dass gemäß eines funktionellen Zusammenhangs                                                                  zwischen einem resultierenden magnetischen

Gradienten $\vec{g}$ und dem resultierenden Vektor $\vec{k}$ des k-Raumes, wobei $t$ eine Zeitabhängigkeit darstellt und eine Orthogonalität der Vektoren $(k_x,0,0)$, $(0,k_y,0)$ und $(0, 0,k_z)$ resultiert. Das griechische Symbol $\gamma$ repräsentiert ein gyromagnetisches Verhältnis zwischen dem magnetischen Drehmoment und dem Drehimpuls der zu untersuchenden Probe. Beispielsweise lässt sich das gyromagnetische Verhältnis von Protonen wie folgt angeben: $\gamma_H = 2\pi \times 42{,}5749 \times 10^6$ rad s$^{-1}$ T$^{-1}$. Eine dergestalte Festlegung auf ein kartesisches Koordinatensystem zur Beschreibung des k-Raumes ist zweckdienlich, aber zur Durchführung des Verfahrens nicht wesentlich. Vielmehr kann eine beliebige Beschreibung des k-Raumes gewählt werden, wobei im Bedarfsfall eine Transformation in das kartesische Koordinatensystem erfolgt.

Zweckmäßigerweise lässt sich der zeitliche Verlauf der Gradienten $g_x$, $g_y$ und $g_z$, der zur spiralförmigen Bedeckung der XY-Ebene des k-Raumes führt, mathematisch wie folgt beschreiben:

$$G_x(t) = r(t)*\cos(\varphi(t))$$

$$G_y(t) = r(t)*\sin(\varphi(t)),$$

$$G_z(t) = 0$$

wobei die Werte für $r(t)$ und $\varphi(t)$ unter Berücksichtigung des Nyquist-Kriteriums bestimmt werden. Die Gradienten sollten zweckmäßigerweise so geschaltet werden, dass sie in möglichst kurzer Zeit einen maximalen Wert erreichen.

Vorzugsweise führt der schwingende zeitliche Verlauf der magnetischen Gradienten $g_x$ und $g_y$ während des Hochfrequenzpulses zu einer vollständigen spiralförmigen Abtastung des abdeckbaren 2-dimensionalen k-Raumes.

In einem besonders bevorzugten Ausführungsbeispiel der Erfindung wird der magnetische Gradient $G_z$ zur weiteren k-Raum-Codierung mindestens abschnittsweise vor den magnetischen Gradienten $G_x$ und $G_y$ geschaltet, wobei der magnetische Gradient $G_z$ einen konstanten zeitlichen Verlauf während einer Schaltdauer aufweist, während $g_x$ und $g_y$ für jede $g_z$-Schaltung ein oder auswärts laufen und so ein Spiralstapel im 3-dimensionalen k-Raum beschrieben wird.

Wahlweise werden weitere Ausgestaltungen an zeitlichen Verläufen der magnetischen Gradienten eingesetzt, die zu weiteren Beschreibungen des k-Raumes führen. Beispielsweise kann der k-Raum durch eine drei-dimensionale Spirale beschrieben werden in dem die Abtastebene der Spiralwindungen beständig im Lauf der Abtastung rotiert wird.

Bei der repräsentativen Darstellung des Volumendatensatzes mittels des drei-dimensionalen k-Raums ergibt sich ein Öffnungswinkel der drei-dimensionalen Spirale mindestens durch die Amplitude des magnetischen Gradienten $G_z$.

Der Erfindung liegt die weitere Aufgabe zugrunde, einen Kernspintomographen bereitzustellen, der sich für die Durchführung des erfindungsgemäßen Verfahrens eignet.

Erfindungsgemäß wird diese Aufgabe durch einen Kernspintomographen mit einem Mittel zur Erzeugung von magnetischen Gradienten, einem Mittel zur Erzeugung von Hochfrequenzpulsen und einem Mittel zur Erzeugung eines statischen Magnetfeldes gelöst, wobei sich der Kernspintomograph dadurch auszeichnet, dass er eine Steuerelektronik zur Durchführung des erfindungsgemäßen Magnetresonanzverfahrens enthält.

Der erfindungsgemäße Kernspintomograph zeichnet sich dadurch aus, dass er N Spulen mit unterschiedlicher räumlicher Sendecharakteristik zur Erzeugung von N Anregungskanälen aufweist.

**Darstellung bevorzugter Ausführungsbeispiele der Erfindung anhand der Abbildungen**

Weitere Vorteile, Besonderheiten und zweckmäßige Weiterbildungen der Erfindung ergeben sich aus der nachfolgenden Darstellung bevorzugter Ausführungsbeispiele anhand der Abbildungen.

Von den Abbildungen zeigt:

Fig. 1  eine schematische Darstellung des Pulserzeugungsvorgangs;

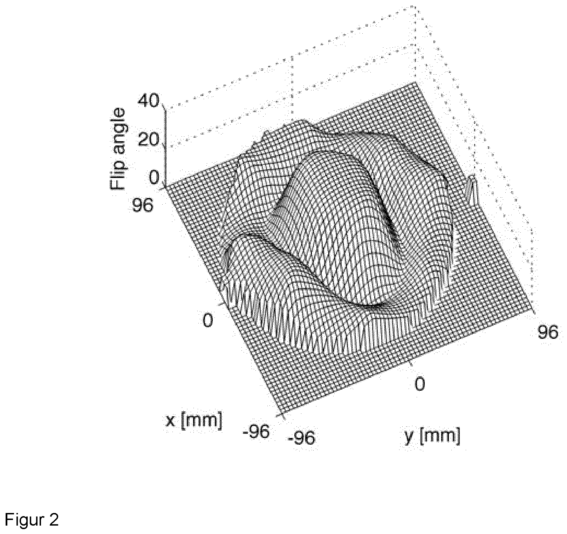

Fig. 2  eine Darstellung der räumlichen Sensivität der Spule und in einem weiteren Teilbild (rechts oben) eine Sensivität gegenüber Schwingungen in einer weiteren Raumebene (y-Ebene);

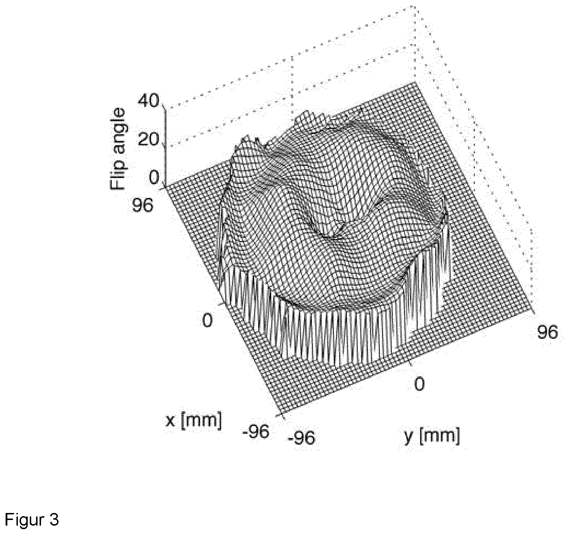

Fig. 3  eine quantitative Darstellung eines Anregungsbildes, wobei in X-und Y-Richtung eine räumliche Verteilung wiedergegeben ist und in der Z-Achse die Signalintensität dargestellt ist;

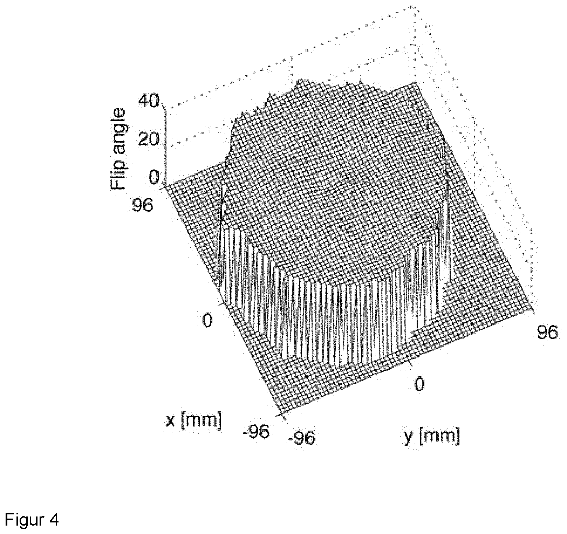

Fig. 4  ein Anregungsmuster wie in Fig. 3, jedoch nach Korrektur von Inhomogenitäten nach einem erfindungsgemäßen Verfahren und

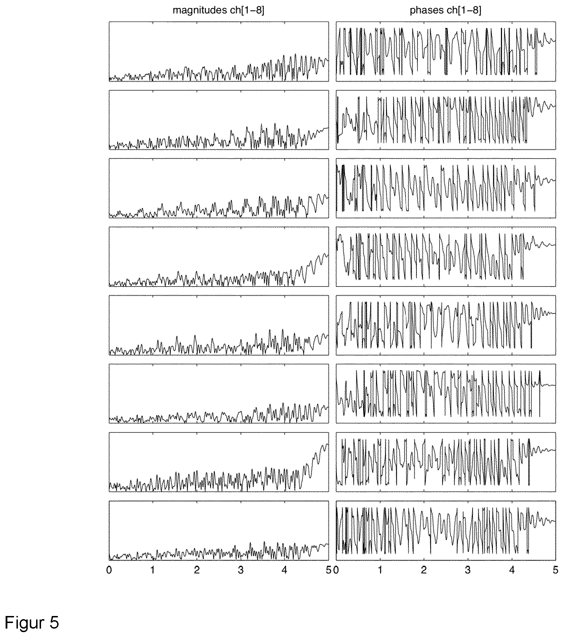

Fig. 5  Amplituden und Phasen zur Erzeugung des Anregungsprofils nach Fig. 4.

Mit der vorgestellten neuen Methode werden selektive Hochfrequenzpulse (Hochfrequenzpulse) für Anwendungen in der Magnetresonanztomographie bestimmt. Das Verfahren nutzt dabei grundsätzliche physikalische und mathematische Prinzipien aus, speziell das Reziprozitätsprinzip sowie die Zeitinvarianz, um damit ein mathematisches Inversionsproblem in eine äquivalente, aber wesentlich einfachere, Beschreibung zu überführen, welche auf der Akquisition eines hypothetischen Magnetresonanzsignals beruht. Dieses Signal ist bis auf Normierungsfaktoren gleich dem gesuchten Hochfrequenzpuls. Folgende Vorteile ergeben sich dadurch gegenüber den bisher bekannten Verfahren:

- Es handelt sich um ein direktes (nicht-iteratives) Verfahren mit einer eindeutigen Lösung,

- die nummerische Lösung ergibt sich durch Superposition analytischer Lösungen und ist somit inhärent parallelisierbar und deshalb sehr schnell verfügbar,
- der Vorgang berücksichtigt unmittelbar Störeinflüsse wie Feldinhomogenitäten und Relaxation, so dass sich die Lösungen robust gegen diese verhalten,
- die Methode ist ohne erhöhten nummerischen Aufwand direkt anwendbar für den Fall multipler Anregungskanäle, d.h. die selektive Anregung mit Hilfe der räumlichen Sensitivitäten mehrerer Hochfrequenz-Anregungsspulen.

Das Verfahren beinhaltet eine Anpassung einer Annäherung für kleine Anregungswinkel (Small-Tip-Angle Approximation, STA) nach Pauly (1988, 1989) unter Berücksichtigung von Verschiebungen der Larmorfrequenz ($\omega_s$). Demnach wird die selektiv angeregte transversale Magnetisierung beschrieben durch:

$$M(\vec{r},T) = i\gamma M_0 \exp[-T/T_2]\exp[-iT\omega_s]\int_0^T \exp[t/T_2]\exp[it\omega_s]b_1(t)\exp[i\vec{k}(t)\cdot\vec{r}]dt \ . \qquad (1)$$

Dabei ist

$M(\vec{r},T)$ : gewünschte transversale Magnetisierung nach der selektiven Anregung,
$t, \vec{r}, T$ : Zeit, Ortsvektor, Dauer des Pulses,
$i, \gamma, M_0$: imaginäre Einheit, gyromagnetisches Verhältnis, Gleichgewichtsmagnetisierung,
$T_2, \omega_s$: Transversale Relaxationszeit, Verschiebung der Resonanzfrequenz ,
$b_1(t), \vec{k}(t)$ : Hochfrequenzpuls, Vektor der k-Raum Trajektorie (gegeben durch Gradienten).

Gleichung (1) ist ein inverses Problem, da sie aufgelöst werden muss nach dem gesuchten Hochfrequenzpuls, $b_1(t)$ , bei vorgegebener k-Raum Trajektorie der Gradienten, $k(t)$, sowie dem vorgegebenen Muster zur Anregung, $M(r,T)$, welches die Zielregion beschreibt. Im Unterschied zur originalen Darstellung von Pauly (1988) unterscheidet sich Gleichung (1) um die zusätzliche Berücksichtigung von Störeinflüssen während des Pulses, d.h. durch die Berücksichtigung von transversaler Relaxation ($T_2$) und Verschiebung der Larmorfrequenz ($\omega_s$), letztere kann z.B. durch auftretende Inhomogenitäten des Hauptfeldes auftreten.
Die neu vorgestellte Methode nutzt nun die Reziprozität von Gleichung (1) zur wohlbekannten Signalgleichung der Magnetresonanz-Bildgebung aus

$$s(t) \quad = \quad \int_V M(\vec{r},T)\exp[t/T_2]\exp[it\omega_s]\exp[-i\vec{k}(T-t)\cdot\vec{r}]\,d^3r \quad , \qquad (2)$$

die in der hier vorliegenden Form allerdings eine Zeitumkehr $t : T \to 0$ beschreibt, d.h. es wird ein hypothetisches Magnetresonanzsignal s(t), resultierend aus einem Untersuchungsvolumen V, rückwärts in der Zeit berechnet entlang der rückwärts durchlaufenen k-Raum Trajektorie k(T-t). Dabei ist die Ausgangsmagnetisierung durch Gleichung (1) und somit durch die Zielregion der selektiven Anregung bestimmt. Die Bestimmung des Magnetresonanzsignals kann entweder durch eine nummerische Simulation von Gleichung (2) oder in bestimmten Fällen auch direkt durch eine Messung erfolgen. Der gesuchte Hochfrequenzpuls ergibt sich dann zu

$$b_1(t) \quad = \quad \frac{J(t)}{i\gamma M_0}s(T-t) \ . \qquad (3)$$

d.h. der Hochfrequenzpuls entspricht bis auf Faktoren dem zeit-invertierten Magnetresonanzsignal. Hierbei ist $J(t)$ die Jacobi-Determinante zur Beschreibung des k-Raum Volumenelements entlang der Trajektorie (Hoge et al, 1997). Bei einer analytisch gegebenen k-Raum Trajektorie lässt sich $J(t)$ explizit berechnen. So gilt z.B. bei einer archimedischen

Spirale $J(t) = \frac{\gamma}{2\pi}|\vec{k}(t)\cdot\vec{g}(t)|$ , $\quad$ (t) $= \frac{2\pi}{\gamma}\frac{\partial\vec{k}(t)}{\partial t}$ die , wobei die Pulsform der Gradienten beschreibt.

Nutzt man wie bei der Erfindung zur Anregung N Spulen mit unterschiedlicher räumlicher Sendecharakteristik, d.h. man verwendet multiple Anregungskanäle (Katscher et al 2003; Zhu, 2004), dann ergibt sich der gesamte Hochfrequenzpuls zu

$$b_1(t,\vec{r}) \quad = \quad \sum_{n=1}^{N} \sigma_n(\vec{r}) b_n(t) \ . \tag{4}$$

Hierbei ist

$\sigma_n(r)$: die Sensitivität des n-ten Kanals, beispielsweise bestimmt durch vorausgehende Messungen,
$b_n(t)$: die gesuchten Hochfrequenzpulse der N Kanäle.

Gleichung (4) in Gleichung (1) eingesetzt liefert die Problemstellung für die selektive Anregung im Mehrkanalfall. Entsprechend zu den Gleichungen (2) und (3) kann auch hier eine Lösung des Problems über ein zeit-invertiertes hypothetisches Magnetresonanzsignal erfolgen, wobei nun N Signale mit entsprechenden komplex konjugierten Empfangssensitivitäten, $\sigma_n^*(r)$, bestimmt werden müssen:

$$s_n(t) = \int_V \sigma_n^*(\vec{r}) M(\vec{r}) \exp[t/T_2] \exp[it\omega_s] \exp[-i\vec{k}(T-t)\cdot\vec{r}] d^3r \tag{5}$$

Gleichung (5) entspricht formal der Signalaufnahme mit mehreren Empfangskanälen (Prüssmann et al, 2001), wobei wieder die Zeitumkehr gemäß Gleichung (2) durchgeführt wird. Werden nun äquivalent zum Einkanalfall diese *N* Signale für die oben beschriebene Magnetisierung entlang der Zeit-invertierten Trajektorie, *k(T-t),* bestimmt - durch eine nummerische Simulation von Gleichung (5) oder durch eine Messung -, dann ergeben sich die gesuchten Hochfrequenzpulse zu

$$b_{1,n}(t) \quad = \quad \frac{J(t)}{i\gamma M_0} s_n(T-t) \ . \tag{6}$$

Insgesamt ist damit die Bestimmung der Hochfrequenzpulse, d.h. die Lösung von Gleichung (1) im Einkanalfall (außerhalb des Schutzumfangs der Erfindung) - bzw. im erfindungsgemäßen Mehrkanalfall unter Berücksichtigung von Gleichung (3) - reduziert auf die Bestimmung von Magnetresonanzsignalen, gegeben durch die Gleichungen (2) bzw. (4), die im Allgemeinen effizient durch nummerische Simulationen ermittelt werden, oder in bestimmten Anwendungen auch direkt durch eine vorausgehende Messung erfolgen können. Die gesuchten Hochfrequenzpulsformen erhält man dann durch eine Umskalierung gemäß den Gleichungen (3) bzw. (6). Der entscheidende Schritt der Interpretation eines Magnetresonanzsignals als Hochfrequenzpuls, gegeben durch die Gleichungen (3) und (6), ist eine Folge des Reziprozitätsprinzips und lässt sich direkt aus den Gleichungen (1) und (2) für den Einkanalfall bzw. (1), (3) und (5) für den Mehrkanalfall mathematisch herleiten, sofern die Sensitivitäten der Spulen günstige Eigenschafen zur Ortskodierung aufweisen, wie bei Prüssmann et al (2001) oder Katscher et al (2003) beschrieben. Abschließend sei angemerkt, dass die beschriebenen Verfahren auch bei schwacher räumlicher Variation der Störeinflüsse (Transversale Relaxation sowie Verschiebung der Resonanzfrequenz) approximativ ihre Gültigkeit behalten, auch wenn diese Abhängigkeit nicht explizit in den Gleichungen erwähnt wurde.
Die Erfindung ist mit einer Vielzahl von Vorteilen verbunden. Insbesondere ist es möglich, Hochfrequenzsignale so zu gestalten, dass eine gewünschte (selektive) Anregung als gezielte Magnetisierung ausgewählter Bereiche eines zu untersuchenden Objektes erzeugt wird.
Die Erfindung und ihre Einsatzgebiete eignen sich für eine Untersuchung einer Vielzahl von zu untersuchenden Objekten, wobei es sich sowohl um Lebewesen als auch um Gegenstände handeln kann. Aufgrund der schnellen Durchführbarkeit und der Vermeidung von Störeinflüssen - beispielsweise durch Streufelder - eignet sich die Erfindung insbesondere zur medizinischen Diagnostik.
Insbesondere ist es möglich, in Echtzeit Hochfrequenzpulse zu erzeugen, durch die Kontrastunterschiede in ausgewählten Volumenbereichen eines zu untersuchenden Objektes möglichst rasch und zuverlässig ermittelt werden können.
Es ist möglich, die Hochfrequenzpulse anhand von einer oder mehreren vorangehenden Untersuchungen des zu untersuchenden Objektes und/oder auf einer Grundlage einer nummerischen Berechnung zu erzeugen.
Vorteile der nummerischen Berechnungen sind die Eindeutigkeit einer ermittelbaren Lösung. Dies ist dadurch gegeben, dass eine analytische Lösung gefunden werden kann.
Für den Fall, dass eine rechnerische Ermittlung der Ausgestaltung der Hochfrequenzpulse erfolgt, ist es möglich, diese Berechnung parallelisiert durchzuführen.
Ferner ist die Erfindung auch bei nicht linearen Gradientenfeldern einsetzbar.

$$m(\mathbf{r}, t) \;=\; \mathrm{i}\gamma m_0(\mathbf{r})\varepsilon(-t)\mathrm{e}^{-\mathrm{i}\mathbf{k}(t)\cdot\mathbf{r}} \int_0^t b_1(\tau)\varepsilon(\tau)\mathrm{e}^{\mathrm{i}\mathbf{k}(\tau)\cdot\mathbf{r}}\, d\tau \qquad (7)$$

Unter Vernachlässigkeit der Relaxation, das heißt, $\varepsilon(t) \equiv 1$ ergibt sich:

$$m(\mathbf{r}, T) \;=\; m(\mathbf{r}) \;=\; \mathrm{i}\gamma m_0(\mathbf{r}) \int_0^T b_1(\tau)\mathrm{e}^{\mathrm{i}\mathbf{k}(\tau)\cdot\mathbf{r}}\, d\tau \qquad (8)$$

Das Magnetresonanzsignal für die zeit-invertierte Trajektorie ergibt sich wie folgt:

$$s(t) = \int_{\mathbb{R}^3} m(\mathbf{r})\mathrm{e}^{-\mathrm{i}\mathbf{k}(t)\cdot\mathbf{r}}\, d\mathbf{r} \qquad (9)$$

Ausgehend von den Gleichungen (7), (8) und (9) ergibt sich:

$$
\begin{aligned}
s(t) \;&=\; \int_{\mathbb{R}^3} m(\mathbf{r})\mathrm{e}^{-\mathrm{i}\mathbf{k}(T-t)\cdot\mathbf{r}}\, d\mathbf{r} \\[2mm]
&=\; \mathrm{i}\gamma m_0 \int_{\mathbb{R}^3}\int_0^T b_1(\tau)\mathrm{e}^{\mathrm{i}[\mathbf{k}(\tau)-\mathbf{k}(T-t)]\cdot\mathbf{r}}\, d\tau\, d\mathbf{r} \\[2mm]
&=\; \mathrm{i}\gamma m_0 \int_0^T b_1(\tau)\delta(\mathbf{k}(\tau)-\mathbf{k}(T-t))\, d\tau \\[2mm]
&=\; \mathrm{i}\gamma m_0 \int_0^T \frac{b_1(\tau)}{J(\tau)}\delta(\mathbf{k}(\tau)-\mathbf{k}(T-t))\, J(\tau)\, d\tau \\[2mm]
&\approx\; \mathrm{i}\gamma m_0 \frac{b_1(T-t)}{J(T-t)} \qquad\qquad (10)
\end{aligned}
$$

Die Hochfrequenzpulse der zeit-invertierten k-Raum-Trajektorie sind das Ergebnis eines korrespondierenden Signals, gewichtet mit der Jacobi-Determinanten. Das Verfahren kann gleichfalls mit mehreren Kanälen angewendet werden. Hierbei werden Übertragungssensitivitäten berücksichtigt, so dass sich die Hochfrequenzpulse als Superposition der individuellen Hochfrequenzpulse der einzelnen Spulen ergeben (Katscher et al. 2003, Zhu 2004).

$$b_1(t, \mathbf{r}) = \sum b_{1,n}(t)\sigma_n(\mathbf{r})$$

ergibt sich für die einzelnen der n Kanäle:

$$s_n(t) = i\gamma m_0 \sum_{m=1}^{N} b_{1,m} * \hat{\sigma}_{nm}(T-t) \qquad (3)$$

Eine Faltung mit einer Indikatorfunktion $\chi(\mathbf{r})$ ist grundsätzlich möglich, um Korrelationen von Empfindlichkeiten einzelner Kanäle zu berücksichtigen. Jedoch ist es auch unter Vernachlässigung dieser Korrelationen möglich, geeignete Ausgestaltungen der Hochfrequenzpulse zu ermitteln.

Die dargestellten Verfahrensschritte sind besonders geeignet, eine gewünschte Pulsform für die Hochfrequenzpulse zu gewinnen.

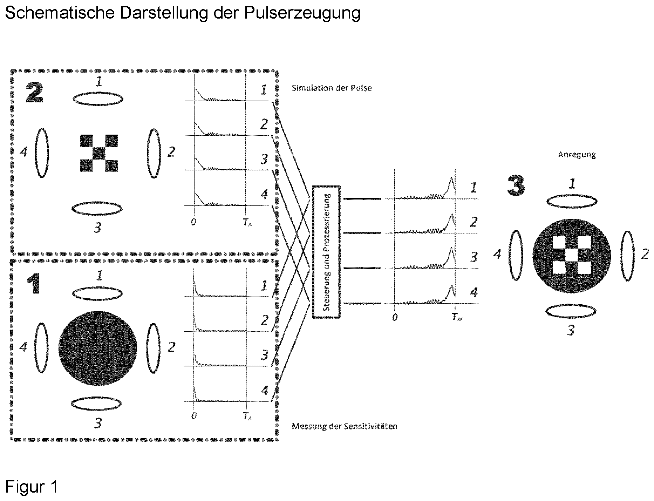

Eine schematische Darstellung der Gewinnung der Hochfrequenzpulse ist in Fig. 1 dargestellt.

Abbildung 1 umreißt den Pulserzeugungsvorgang. Das Steuerungs- und Prozessierungsmodul misst die Sensitivitäten der verwendeten Spulen. Diese werden komplex konjugiert und für die Simulation der hypothetischen Bildgebung des exemplarischen Schachbrettmusters verwendet wobei die Signale für die einzelnen Spulen gewonnen werden. Nach dem die Prozessierung durch die Berücksichtigung der Koordinatentransformation von k nach t durch die Gewichtung mit der Jacobi-Determinanten erfolgt ist werden diese Pulse für die Anregung verwendet.

Die erfindungsgemäßen Magnetresonanzverfahren können bei beliebigen Kernspintomographen und bei einem weiten Bereich von Magnetfeldstärken eingesetzt werden, sofern sie in den Schutzumfang von Anspruch 4 fallen.

Es ist jedoch besonders vorteilhaft, die vorliegende Erfindung bei hohen Magnetfeldstärken, insbesondere bei Magnetfeldstärken oberhalb von 6 T einzusetzen. Hintergrund hierfür ist, dass bei höheren Magnetfeldstärken stärkere Störfelder auftreten können.

Insbesondere ist es möglich, dass sich bei hohen Magnetfeldstärken und/oder hohen Anregungsfrequenzen, vorzugsweise von mehreren hundert MHz Streufelder bilden. Erfindungsgemäß werden diese Streufelder durch die dargestellten Maßnahmen verhindert. Im nachfolgenden Beispiel wird eine hohe Anregungsfrequenz von 400 MHz eingesetzt.

Die nachfolgenden experimentellen Resultate wurden für 1,000,000 Isochromaten für eine dreidimensionale Spiral-Trajektorie von 5,12 ms Dauer innerhalb eines Clusters mit einer Recheneinheit, bestehend aus beispielsweise 16 AMD Opteron 2378 8-Kern CPUs beispielsweise jeweils betrieben mit 2,4 GHz innerhalb 1:20 min.

Zunächst wird eine zu untersuchende Probe dem statischen Hauptmagnetfeld ausgesetzt, wobei sich die makroskopische Magnetisierung ausbildet und parallel zum Verlauf des Hauptmagnetfeldes ausrichtet, was der Ausrichtung des Gleichgewichtszustandes entspricht. In diesem Gleichgewichtszustand ist eine transversale Komponente der makroskopischen Magnetisierung klein oder gleich Null.

Der applizierte Hochfrequenzpuls saturiert die makroskopische Magnetisierung. Die Erfassungszeit von Daten hängt theoretisch zumindest vom Leistungsumfang des verwendeten Gradientensystems, von etwaigen physiologischen Faktoren der zu untersuchenden Probe (elektrophysiologische Reizschwelle der Muskulatur etc.) ab.

Bei der zu untersuchenden Probe kann es sich um eine Vielzahl von Lebewesen einschließlich des Menschen sowie auch um unbelebte Objekte handeln. Insbesondere eignet sich die Erfindung für eine Ermittlung, genaue Lokalisierung, Spezifizierung von Unterschieden wenigstens eines zu untersuchenden Materialparameters.

Bei dem zu untersuchenden Volumen handelt es sich insbesondere um ein oder mehrere Teilbereiche des zu untersuchenden Objektes, wobei eine gesamte Erfassung des Objekts gleichfalls mit umfasst ist.

Die vorangegangene Darstellung bezieht sich auf bevorzugte Ausgestaltungen der Erfindung. Es ist selbstverständlich möglich, die einzelnen dargestellten Maßnahmen unabhängig voneinander einzusetzen, sofern hierdurch der durch die Ansprüche definierte Schutzumfang der Erfindung nicht verlassen wird.

**Symbole**

$\gamma$ Gyromagnetisches Verhältnis

$m_0$ Gleichgewichtsmagnetisierung

$\mathbf{r}$ Ortskoordinate

k($t$) k-Raum-Trajektorie

$m(T, \mathbf{r})$ Gewünschte transversale Magnetisierung

$b_{1,n}(t)$        Hochfrequenzfeld

$\chi(r)$         Indikatorfunktion für das zu untersuchende Volumen

$\wedge$         3D Fourier Transformation des k-Raums

$\sigma_n(\mathbf{r})$        Sensitivität der n-ten Spule, entsprechend der Sensitivität des n-ten Kanals

$\sigma_{nm}(\mathbf{k})$      Korrelationsmatrix

**Patentansprüche**

1. Magnetresonanzverfahren mit einer Erzeugung von Hochfrequenzpulsen und magnetischen Gradienten ($g_x$, $g_y$, $g_z$) zur selektiven Anregung eines sich in einem Untersuchungsvolumen befindenden zu untersuchenden Objektes, wobei zur Anregung N>1 Spulen mit unterschiedlichen räumlichen Sendecharakteristiken $\sigma_n(r)$ mittels N entsprechenden Sendekanälen verwendet werden, wobei $\sigma_n(r)$ die räumliche Sendecharakteristik der n-ten Spule bezeichnet, wobei das Magnetresonanzverfahren folgende Schritte umfasst,

     - Vorgeben einer transversalen Magnetisierung $m(r,\mathrm{T})$ die beschrieben wird durch

$$m(\mathbf{r},T) = i\gamma m_0 \exp[-T/T_2] \exp[-iT\omega_s] \int_0^T \exp[t/T_2] \exp[it\omega_s] \, b_1(t,\mathbf{r}) \, \exp[i\mathbf{k}(t)\cdot\mathbf{r}] \, dt$$

     wobei $i$ eine imaginäre Einheit, $\gamma$ ein gyromagnetisches Verhältnis, $m_0$ eine Gleichgewichtsmagnetisierung, $t$ eine Zeit, $r$ einen Ortsvektor, T eine Dauer eines Pulses, $T_2$ eine transversale Relaxationszeit und $\omega_s$ eine Verschiebung der Resonanzfrequenz bezeichnet und $k(t)$ ein Vektor einer k-Raum Trajektorie ist, welcher durch die magnetischen Gradienten gegeben ist, und wobei $b_1(t,r)$ die Überlagerung der individuell sensitivitätsgewichteten Hochfrequenzpulse $b_{1,n}(t)$ an jedem Ort r bezeichnet, die gemäß der nachfolgenden Formel bestimmt wird,

$$b_1(t,\mathbf{r}) = \sum_{n=1}^{N} \sigma_n(\mathbf{r}) \, b_{1,n}(t)$$

     - Bestimmen der Hochfrequenzpulse mittels einer Signalgleichung $s_n(t)$ gemäß:

$$s_n(t) = \int^V \sigma_n^*(\mathbf{r}) \, m(\mathbf{r}) \, \exp[t/T_2] \, \exp[it\omega_s] \, \exp[-i\mathbf{k}(T-t)\cdot\mathbf{r}] \, d^3r,$$

     wobei $V$ ein Untersuchungsvolumen bezeichnet, und wobei $\sigma_n^*(r)$ der komplex konjugierten Sendecharakteristik der n-ten Spule entspricht, so dass sich die gesuchten Hochfrequenzpulse $b_{1,n}(t)$ der einzelnen N Sendekanäle bis auf Faktoren zu $b_{1,n}(t) = s_n(T-t) \, J(t) / (i\gamma m_0)$ ergeben, wobei $J(t)$ eine Jacobi-Determinante ist, die unter der Prämisse der Bijektivität von $k(t)$ auf dem Wertebereich von t die Abhängigkeit der Koordinatentransformation zwischen einer Zeit- und der k-Raum-Parametrisierung leistet,
     - Anregen des Untersuchungsvolumens mit den Hochfrequenzpulsen,
     - Erfassen des durch die Hochfrequenzpulse im Untersuchungsvolumen erzeugten Messsignals, und
     - Auswerten des Messsignals.

2. Magnetresonanzverfahren nach Anspruch 1,
     **dadurch gekennzeichnet, dass** die Sensitivität $\sigma_n(r)$ anhand einer numerischen Bestimmung ermittelt wird.

3. Magnetresonanzverfahren nach Anspruch 1 oder 2,
     **dadurch gekennzeichnet,**
     **dass** die Sensitivität $\sigma_n(r)$ durch eine oder mehrere Messungen eines Magnetresonanzsignals des zu untersuchenden Objektes erfolgt, so dass das Bestimmen der Hochfrequenzpulse unter Berücksichtigung der einen oder der mehreren vorausgehenden Messungen erfolgt.

4. Kernspintomograph mit einem Mittel zur Erzeugung von magnetischen Gradienten, einem Mittel zur Erzeugung von Hochfrequenzpulsen, einem Mittel zur Erzeugung eines statischen Magnetfeldes und einem Mittel zur Datenakquisition, wobei der Kernspintomograph N Spulen mit unterschiedlicher räumlicher Sendecharakteristik zur Erzeugung von N Sendekanälen aufweist, wobei die Zahl N größer 1 und nicht prinzipiell nach oben hin begrenzt ist **dadurch gekennzeichnet,**
**dass** der Kernspintomograph eine Steuerelektronik enthält, welche zur Durchführung eines Magnetresonanzverfahrens nach einem der Ansprüche 1 bis 3 ausgestaltet ist.

**Claims**

1. A magnetic resonance method involving the generation of high-frequency pulses and magnetic gradients ($g_x$, $g_y$, $g_z$) for the selective excitation of an object to be examined that is located in an examination volume, wherein N>1 coils having different spatial transmission characteristics $\sigma_n(r)$ are used for the excitation by means of N corresponding transmission channels, wherein $\sigma_n(r)$ refers to the spatial transmission characteristic of the n$^{th}$ coil, the magnetic resonance method comprising the following steps:

   - providing a transversal magnetization $m(r,T)$ which is described by

$$m(\boldsymbol{r}, T) = i\gamma m_0 \, exp\left[-T/T_2\right] exp[-iT\omega_s] \int_0^T exp[t/T_2] \exp[it\omega_s] \, b_1(t, \boldsymbol{r}) \exp[i\boldsymbol{k}(t) \cdot \boldsymbol{r}] \, dt$$

   wherein $i$ stands for an imaginary unit, $\gamma$ stands for a gyromagnetic ratio, $m_0$ stands for an equilibrium magnetization, $t$ stands for a time, $r$ stands for a position vector, $T$ stands for a duration of a pulse, $T_2$ stands for a transversal relaxation time, and $\omega_s$ stands for a shift of the resonance frequency, $k(t)$ is a vector of a k-space trajectory that is given by the magnetic gradients, and wherein $b_1(t,r)$ stands for the superposition of the individual sensitivity-weighted high-frequency pulses $b_{1,n}(t)$ at each location $r$ which is determined by the formula

$$b_1(t, \boldsymbol{r}) = \sum_{n=1}^{N} \sigma_n(\boldsymbol{r}) b_{1,n}(t)$$

   - determining the high-frequency pulses by means of a signal equation $s_n(t)$ according to:

$$s_n(t) = \int^V \sigma_n{}^*(\boldsymbol{r}) m(\boldsymbol{r}) \exp[t/T_2] \exp[it\omega_s] \exp[-i\boldsymbol{k}(T-t) \cdot \boldsymbol{r}] \, d^3r$$

   wherein $V$ stands for an examination volume, and wherein $\sigma_n{}^*(r)$ corresponds to the complexly conjugated transmission characteristic of the n$^{th}$ coil, so that the sought high-frequency pulses $b_{1,n}(t)$ of the individual N transmission channels, upon factors, are obtained as:

$$b_{1,n}(t) = s_n(T-t) \, J(t) \, / \, (i\gamma m_0)$$

   wherein $J(t)$ is a Jacobi determinant that, under the premise of the bijectivity of $k(t)$ on the value range of $t$, yields the dependence of the coordinate transformation between a time parameterization and the k-space parameterization,
   - exciting the examination volume with the high-frequency pulses,
   - detecting the measured signal generated by the high-frequency pulses in the examination volume, and
   - evaluating the measured signal.

2. The magnetic resonance method according to claim 1,

**characterized in that**
the sensitivity $\sigma_n(\mathbf{r})$ is determined on the basis of a numerical definition.

3. The magnetic resonance method according to claim 1 or 2,
   **characterized in that**
   the sensitivity $\sigma_n(\mathbf{r})$ is determined by means of one or more measurements of a magnetic resonance signal of the object to be examined, so that the high-frequency pulse is determined in consideration of the one or more preceding measurements.

4. A nuclear spin tomograph having a means for generating magnetic gradients, a means for generating high-frequency pulses, a means for generating a static main magnetic field, and a means for data acquisition, wherein the nuclear spin tomograph comprises N coils having a different spatial transmission characteristic for generating N transmission channels, wherein the number N is greater than 1 and in principle not limited upwards, **characterized in that** the nuclear spin tomograph includes control electronics for carrying out a magnetic resonance method according to any one of claims 1 to 3.

**Revendications**

1. Procédé de résonance magnétique avec une génération d'impulsions haute fréquence et de gradients magnétiques $(g_x, g_y, g_z)$ pour l'excitation sélective d'un objet à examiner se trouvant dans un volume d'examen, dans lequel N>1 bobines dotées de caractéristiques spatiales d'émission différentes sont utilisées pour l'excitation au moyen de N canaux d'émission correspondants, dans lequel $\sigma_n(\mathbf{r})$ désigne la caractéristique spatiale d'émission de la *n*-ième bobine, dans lequel le procédé de résonance magnétique comprend les étapes suivantes,

   - définition d'une magnétisation transversale $m(\mathbf{r},T)$, laquelle est décrite par $m(\mathbf{r},T) =$

   $$i\gamma m_0 e^{-T/T_2} e^{-iT\omega_s} \int_0^T e^{t/T_2} e^{-it\omega_s} b_1(t,\mathbf{r}) e^{-ik(t)\cdot\mathbf{r}} dt$$ , dans lequel i désigne une unité imaginaire, $\gamma$ un rapport gyromagnétique, $m_0$ une magnétisation d'équilibre, $t$ un temps, $\mathbf{r}$ un vecteur de position, T une durée d'une impulsion, $T_2$ un temps de relaxation transversale et $\omega_s$ un déplacement de la fréquence de résonance et $k(t)$ est un vecteur d'une trajectoire d'espace k, lequel est donné par les gradients magnétiques, et dans lequel $b_1(t,\mathbf{r})$ désigne la superposition des impulsions haute fréquence pondérées individuellement en sensibilité $b_{1,n}(t)$ en chaque position $\mathbf{r}$, laquelle est quantifiée selon la formule suivante,

   $$b_1(t,\mathbf{r}) = \sum_{n=1}^{N} \sigma_n(\mathbf{r}) b_{1,n}(t)$$

   - quantification des impulsions haute fréquence au moyen d'une équation de signal $s_n(t)$ selon $s_n(t) = \int^V \sigma_n(r)m(r)e^{t/T_2}e^{-it\omega s}e^{-ik(T-t)\cdot r}d^3r$, dans lequel V désigne un volume d'examen, et dans lequel $\sigma_n^*(\mathbf{r})$ correspond à la caractéristique complexe conjuguée d'émission de la n-ième bobine, de sorte que les impulsions haute fréquence $b_{1,n}(t)$ recherchées des N différents canaux d'émission se produisent à des facteurs près de $b_{1,n}(t) = s_n(T - t)J(t)/(i\gamma m_0)$, dans lequel $J(t)$ est un déterminant jacobien, lequel fournit la relation de la transformation des coordonnées entre une paramétrisation temporelle et la paramétrisation dans l'espace k, en supposant la bijectivité de $k(t)$ sur l'intervalle de valeurs de t,
   - excitation du volume d'examen avec les impulsions haute fréquence,
   - détection du signal de mesure obtenu par les impulsions haute fréquence dans le volume d'examen, et
   - analyse du signal de mesure.

2. Procédé de résonance magnétique selon la revendication 1, **caractérisé en ce que** la sensibilité $\sigma_n(r)$ est déterminée à l'aide d'une quantification numérique.

3. Procédé de résonance magnétique selon la revendication 1 ou 2, **caractérisé en ce que** la sensibilité $\sigma_n(r)$ est obtenue par une ou plusieurs mesures d'un signal de résonance magnétique de l'objet à examiner, de sorte que la quantification des impulsions haute fréquence est obtenue en prenant en compte l'une ou les plusieurs mesures précédentes.

**4.** Tomographe à spin nucléaire doté d'un moyen de génération de gradients magnétiques, d'un moyen de génération d'impulsions haute fréquence, d'un moyen de génération d'un champ magnétique statique et d'un moyen d'acquisition de données, dans lequel le tomographe à spin nucléaire comporte N bobines dotées de caractéristiques spatiales d'émission différentes destinées à la génération de N canaux d'émission, dans lequel le nombre N est supérieur à 1 et n'a en principe pas de limite supérieure,

**caractérisé en ce que** le tomographe à spin nucléaire contient une électronique de commande, laquelle est configurée pour mettre en œuvre un procédé de résonance magnétique selon l'une des revendications 1 à 3.

Schematische Darstellung der Pulserzeugung

Figur 1

Figur 2

Figur 3

Figur 4

magnitudes ch[1–8]        phases ch[1–8]

Figur 5

EP 2 676 151 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102004057030 A1

- DE 102006058162 B3

**In der Beschreibung aufgeführte Nicht-Patentliteratur**

- **P. MANSFIELD ; P. G. MORRIS.** MMR Imaging in Biomedicine. Academic Press, 1982
- **P. T. CALLAGHAN.** Principles of Nuclear Magnetic Resonance Microscopy. Clarendon Press, 1991
- **E. MARK HAACKE et al.** Magnetic Resonance Imaging. Wiley-Liss, 1999
- **PAULY et al.** A k-Space Analysis of Small-Tip-Angle Excitation. *J Magn Reson,* 1998, vol. 81 (1), 43-56
- **PAULY et al.** A Linear Class of Large-Tip-Angle Selective Excitation Pulses. *J Magn Reson,* 1989, vol. 82 (3), 571-587
- **KATSCHER et al.** Theoretiocal and nummerical aspects of transmit SENSE. *IEEE T Med Img,* 2004

- **ZHU.** Parallel excitation with an array of transmit coils. *Magn Reson Med,* 2004, vol. 51 (4), 775-84
- **HOGE et al.** Density Compensation Functions for Spiral MRI. *Magn Reson Med,* 1997, vol. 38 (1), 117-128
- **JUSTIN D. PEARLMAN et al.** Relaxivity corrected response modulated excitation (RME): A T2-corrected technique achieving specified magnetization patterns from an RF pulse and a time-varying magnetic field. *Magnetic Resonance in Medicine,* 01. Januar 1994, vol. 32, 388-395
- An NMR technique for measurement of magnetic field gradient waveforms. **JELLUS V et al.** Journal of Magnetic Resonance. Academic Press, 01. Mai 2003, vol. 162, 189-197